# EUROPEAN PATENT APPLICATION

(11) **EP 1 081 850 A2**
(43) Date of publication of application: **07.03.2001**
(21) Application number: 00118763.2
(22) Date of filing: 30.08.2000
(51) Int. Cl.: H03G 3/30

(54) **Power amplifying apparatus for mobile phone**

(30) Priority: 31.08.1999 JP 24643599
(71) Applicant: SAMSUNG ELECTRONICS CO., LTD., Suwon-City, Kyungki-do (KR)
(72) Inventor: Haruyama, Shinichi, Tsurumi-ku, Yokohama-shi, Kanagawa-ken (JP)
(74) Representative: Grünecker, Kinkeldey, Stockmair & Schwanhäusser Anwaltssozietät

(57) **Abstract**

A power amplifying apparatus for a mobile phone. In the power amplifying apparatus, a power amplifier uses a transistor as a power amplifying device, and a non-volatile memory records the static characteristic measurement data of the transistor. A DC bias current of the transistor is controlled according to transmission power of the power amplifier referring to the static characteristic measurement data, by changing a gate voltage of the transistor, changing a drain voltage of the transistor with the gate voltage fixed, or changing both the gate voltage and the drain voltage.

## Description

The present invention relates generally to extension of the life span of a battery, and in particular, to a power amplifying apparatus for a W-CDMA (Wideband-Code Division Multiple Access) mobile phone.

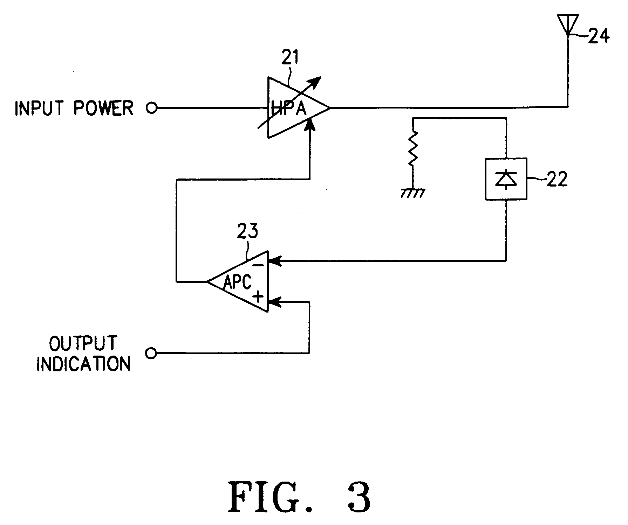

A mobile phone determines the distance between the mobile phone and a base station and controls its transmission power by monitoring its reception power. FIG. 3 illustrates the structure of a power amplifying apparatus in a mobile phone. In FIG. 3, a high power amplifier (HPA) 21 amplifies the power of an input signal under the control of an automatic power controller (APC) 23 and feeds an amplified signal to a transmission antenna 24. A power monitor 22 monitors transmission power received from the HPA 21. The APC 23 controls the transmission power of the HPA 21 according to an output indication received from a digital signal processor (DSP: not shown) for a phone or a controlling CPU (Central Processing Unit: not shown) and the output of the output monitor 22. The output indication is a DC signal resulting from subjecting a digital signal output from the DSP or the CPU to digital-to-analog conversion (DAC). This DC signal is used to control the transmission power in a protocol, for example.

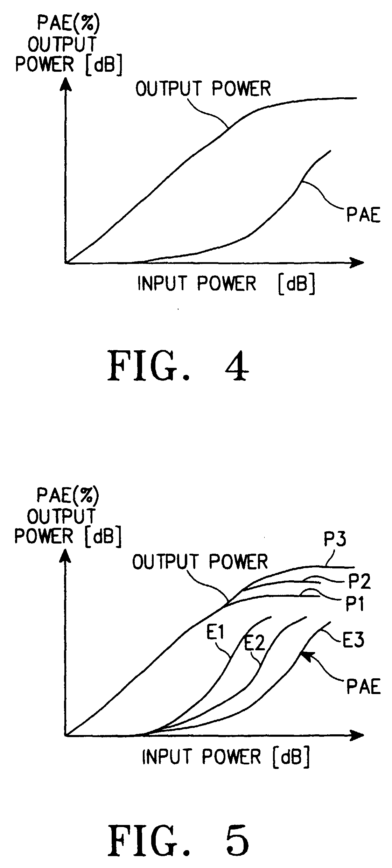

The power added efficiency (PAE) of the HPA 21 is a significant factor that determines the life span of a battery. FIGs. 4 and 5 are graphs showing the relation between input/output power characteristics and PAE that determines power consumption.

For example, the HPA 21 using a GaAs-FET as a power amplifying apparatus is configured in such a way that a maximum PAE is obtained in the vicinity of a peak transmission power, as shown in FIG. 4. However, when the peak transmission power is requested with low frequency in a normal use state, the life span of a battery in real use is effectively extended by increasing the PAE of low/middle power used with high frequency.

In view of the foregoing, various suggestions have been made. As shown in FIG. 5, a DC bias current flowing through the HPA 21 is generally controlled based on the output of the HPA 21. Curves P1, P2, and P3 representative of output power match with curves E1, E2, and E3 representative of PAE. P1 and E1 are for a relatively low DC bias current, whereas P3 and E3 are for a relatively high DC bias current.

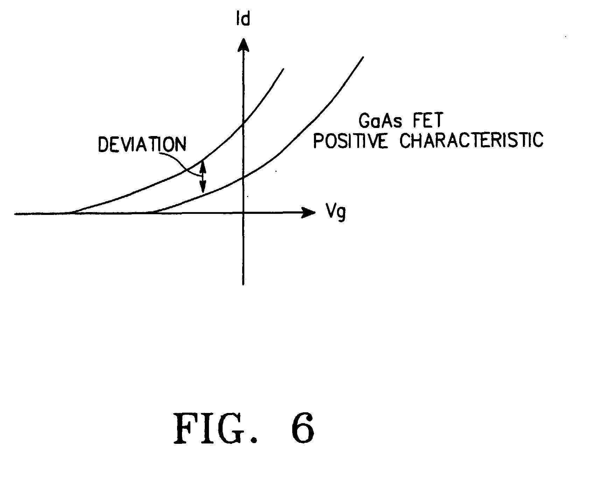

A GaAs-FET, a transistor showing high efficiency, is usually used as a power amplifying device for an HPA. Positive characteristics differ in GaAs-FETs as shown in FIG. 6. FIG. 6 shows that two GaAs-FETs have different individual static characteristics.

To control a drain current Id of FIG. 6 to an optimal point, the individual difference in the static characteristics of devices should be minimized. However, this is impossible in the current situation since it is expected that degradation of product yield will increase cost.

It is, therefore, the object of the present invention to provide a power amplifying apparatus for a mobile phone, which can increase the life span of a battery in a normal use state by precisely controlling a DC bias current that determines the PAE of a power amplifier since it is important to increase the PAE at a low/middle transmission power level used highly frequently in order to increase the average PAE of the power amplifying apparatus.

The above object can be achieved by providing a power amplifying apparatus for a mobile phone. In the power amplifying apparatus, a power amplifier uses a transistor as a power amplifying device, and a non-volatile memory records the static characteristic measurement data of the transistor. A DC bias current of the transistor is controlled according to transmission power of the power amplifier referring to the static characteristic measurement data, by changing a gate voltage of the transistor, changing a drain voltage of the transistor with the gate voltage fixed, or changing both the gate voltage and the drain voltage.

The above and other objects, features and advantages of the present invention will become more apparent from the following detailed description when taken in conjunction with the accompanying drawings in which:
FIG. 1 is a schematic view of a power amplifying apparatus for a mobile phone according to an embodiment of the present invention;
FIG. 2A is a flowchart illustrating a preliminary process in a manufacture company of the power amplifying apparatus shown in FIG. 1;
FIG. 2B is a flowchart illustrating the operation of a bias controller shown in FIG. 1;
FIG. 3 illustrates the structure of a power amplifying apparatus in a conventional mobile phone;
FIG. 4 is a graph showing the relationship between input/output power characteristics and PAE in an HPA;
FIG. 5 is a graph showing the relationship between input/output power characteristics and PAE in the HPA when a DC bias current of the HPA is controlled according to HPA output; and
FIG. 6 is a graph showing static characteristic data of GaAs-FETs used as power amplifying devices for the HPA.

A preferred embodiment of the present invention will be described hereinbelow with reference to the accompanying drawings. In the following description, well-known functions or constructions are not described in detail since they would obscure the invention in unnecessary detail.

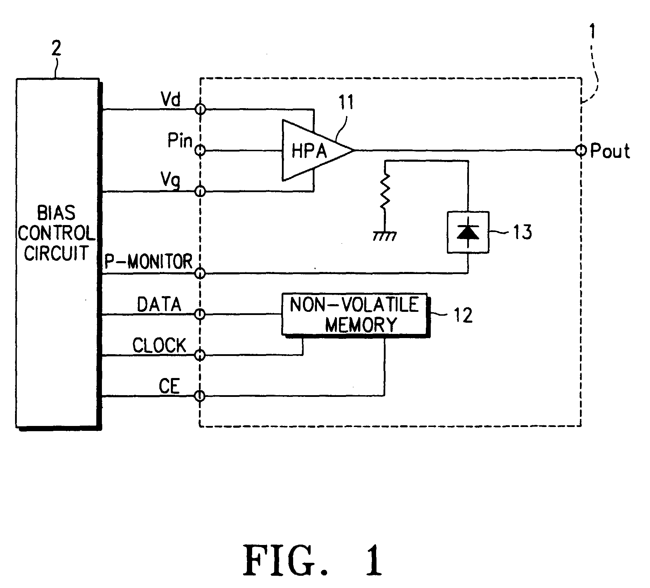

FIG. 1 is a schematic view of a power amplifying apparatus (hereinafter, referred to as an HPA module) for a mobile phone according to the present invention. In FIG. 1, an HPA 11, a non-volatile memory 12, and an output monitor 13 are incorporated in the HPA module 1 on one chip. GaAs-FET is used as a power amplifying device for the HPA 11 that includes a bias current setting circuit later described. An EEPROM (Electrically Erasable Programmable Read Only Memory) is used as the non-volatile memory 12, by way of example.

The static characteristic data of the GaAs-FET is recorded preliminarily in the non-volatile memory 12. Specifically, the static characteristic of the GaAs-FET, that is, its Vg-Id characteristic as shown in FIG. 6 is measured, plotted to 16 (=2⁴) kinds of data when a 4-bit EEPROM is used, and recorded in the non-volatile memory 12, before the HPA module 11 comes onto the market.

In FIG. 1, Vd (drain voltage), Pin (input voltage), Vg (gate voltage), P-monitor (power monitor), Data (data), clock (clock signal), CE (chip enable), and Pout (output power) are the input/output terminals of the HPA module 1. When the HPA module 1 is used as a power amplifying apparatus for the mobile phone, Vd, Pin, Vg, P-monitor, Data, clock, and CE are connected to a bias control circuit 2 outside the HPA module 1. The bias control circuit 2 can be implemented by use of a phone DSP or a controlling CPU.

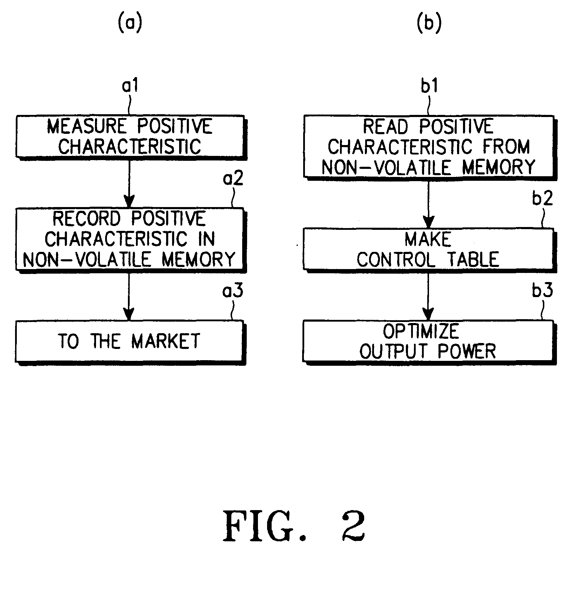

FIG. 2A illustrates a preliminary operation in a manufacture company of the HPA module 1 shown in FIG. 1 and FIG. 2B is a flowchart illustrating the operation of the bias control circuit 2 when the HPA module 1 is used as a power amplifying apparatus for a mobile phone.

Referring to FIGs. 2A and 2B, the non-volatile memory 12 is incorporated in the HPA module 1, as stated above. Before the HPA module 1 comes onto the market, the static characteristic of the GaAs-FET (HPA 11) is measured in step a1. The measured static characteristic is recorded in the non-volatile memory 12 in step a2. In step a3, the HPA module 1 is put on the market.

When the HPA module 1 is used a power amplifying apparatus for a mobile phone, the bias control circuit 2 reads the data from the non-volatile memory 12 in step b1, makes a control table in step b2, and optimizes the output power of the HPA 11 according to the contents of the control table in step b3.

Optimization of output power refers to control of the output power based on the individual static characteristic data of the GaAs-FET read from the non-volatile memory 12. In other words, the bias control circuit 2 changes the drain voltage Vd or the gate voltage Vg applied to the HPA 11 according to the output power Pout of the HPA 11 monitored by the output monitor 13, to thereby control a DC bias current flowing through the HPA 11.

Specifically, the bias control circuit 2 reads the static characteristic of the GaAs-FET (i.e., the Vg-Id characteristic shown in FIG. 6) from the non-volatile memory 12, makes a control table for setting a DC bias current based on the read static characteristic, and controls the DC bias current so as to maximize PAE referring to the control table. Consequently, the output power of the HPA 11 is optimized.

The DC bias current can be controlled in three ways: (1) by changing the gate voltage Vg; (2) by changing the drain voltage Vd with the gate voltage Vg fixed and; and by changing both the gate voltage Vg and the drain voltage Vd.

Using one of the above three methods, the output power of the HPA 11 is optimized without reducing PAE. Hence, the control table made in the bias control circuit 2 varies depending on which method is used.

When the DC bias current is controlled by changing the gate voltage Vg, the control table is

**Table 1**

| gate voltage Vg | DC bias current | PAE |
|---|---|---|
| V_{g}1 | iₖ1 | k1 |
| V_{g}2 | iₖ2 | k2 |
| V_{g}3 | iₖ3 | k3 |
| V_{g}4 | iₖ4 | k4 |

When the DC bias current is controlled by changing the drain voltage Vd with the gate voltage Vg fixed, the control table is

**Table 2**

| drain voltage Vd | DC bias current | PAE |
|---|---|---|
| V_{d}1 | iₖ1 | k1 |
| V_{d}2 | iₖ2 | k2 |
| V_{d}3 | iₖ3 | k3 |
| V_{d}4 | iₖ4 | k4 |

When the DC bias current is controlled by changing the gate voltage Vg and the drain voltage Vd, the control table is

**Table 3**

| gate voltage Vg | drain voltage Vd | DC bias current | PAE |
|---|---|---|---|
| V_{g}1 | V_{d}1 | iₖ1 | k1 |
| V_{g}1 | V_{d}2 | iₖ2 | k2 |
| V_{g}1 | V_{d}3 | iₖ3 | k3 |
| V_{g}2 | V_{d}1 | iₖ4 | k4 |
| V_{g}2 | V_{d}2 | iₖ5 | k5 |
| V_{g}2 | V_{d}3 | iₖ6 | k6 |
| : | : | : | : |

In case the DC bias current is controlled by varying the gate voltage Vg, a gate voltage Vg that maximizes the PAE is selected referring to the control table of Table 1 and applied to the HPA 11, thereby optimizing the output power of the HPA 11.

The DC bias current applied by the bias control circuit 2 based on the drain voltage Vd and/or gate voltage Vg flows through the HPA 11 through the bias current setting circuit. The structure of the bias current setting circuit is well known and thus its detailed description is omitted here.

The consumption power of the HPA module 1 is defined as the product of a DC bias current and a power supply voltage. If the DC bias current is constant as in the conventional technology, the HPA module 1 consumes power that is almost constant despite low output power. To increase the average PAE of the HPA module 1, it is important to increase its PAE at relatively low/middle output power. Therefore, the DC bias current should be controlled since it determines the PAE. At a low output power level, the DC bias current is controlled low. This implies that if the output power level is set to a low level, the DC bias current is also set to be a low value, for example, by setting the drain voltage Vd to thereby increase the PAE.

Meanwhile, the DC bias current can be precisely controlled by increasing the capacity of the non-volatile memory 12.

While an EEPROM is used as the non-volatile memory 12, the present invention is not limited to the EEPROM. Any ROM can be a candidate for use as the non-volatile memory 12 as long as it is rewritable, such as a flash memory, a FAMOS (Floating Avalanche MOS), and a SAMOS (Stacked-gate Avalanche MOS).

In addition, the bias control circuit 2 is implemented by use of a phone DSP or a controlling CPU outside the HPA module 1 in the embodiment, but it can be further contemplated that the bias control circuit 2 is configured to be a circuit dedicated to the exclusive purpose of bias current control and incorporated in the HPA module 1.

As described above, an HPA module of the present invention incorporates a non-volatile memory therein and has the static characteristic data of the HPA preliminarily measured and recorded in the non-volatile memory before it is put on the market. In operation, the data is read and the output power of the HPA is controlled based on the individual static characteristic of the HPA. By precisely controlling the DC bias current of the HPA, the life span of a battery can be extended. Especially, the present invention is highly effective in a W-CDMA mobile phone that has difficulty achieving a high efficiency (low power) power amplifying apparatus.

While the invention has been shown and described with reference to a certain preferred embodiment thereof, it will be understood by those skilled in the art that various changes in form and details may be made therein without departing from the spirit and scope of the invention as defined by the appended claims.

## Claims

1. A power amplifying apparatus for a mobile phone, comprising:
a power amplifier; and
a non-volatile memory for recording the static characteristic measurement data of a transistor used as a power amplifying device of the power amplifier,
wherein a DC bias current of the transistor is controlled according to transmission power of the power amplifier referring to the static characteristic measurement data.

2. The power amplifying apparatus of claim 1, further comprising a bias control circuit for controlling the DC bias current of the transistor.

3. The power amplifying apparatus of claim 2, wherein the power amplifier, the non-volatile memory and the DC bias control circuit are incorporated on one chip.

4. The power amplifying apparatus of one of the claims 1 to 3, wherein the DC bias current is controlled by changing a gate voltage applied to the power amplifying device referring to the static characteristic data.

5. The power amplifying apparatus of one of the claims 1 to 3, wherein the DC bias current is controlled by fixing a gate voltage applied to the power amplifying device and changing a drain voltage applied to the power amplifying device referring to the static characteristic data.

6. The power amplifying apparatus of one of the claims 1 to 3, wherein the DC bias current is controlled by changing both a gate voltage and a drain voltage applied to the power amplifying device referring to the static characteristic data.
